**Europäisches Patentamt**

**European Patent Office**

**Office européen des brevets**

(11) Veröffentlichungsnummer: **0 007 115**
**B1**

(12) # EUROPÄISCHE PATENTSCHRIFT

(45) Veröffentlichungstag der Patentschrift:
**12.08.81**

(21) Anmeldenummer: **79102499.5**

(22) Anmeldetag: **18.07.79**

(51) Int. Cl.³: **H 05 F 3/02, H 01 J 37/02,**
**C 23 C 17/00, H 01 H 1/02**

(54) **Bauteil aus metallischem Werkstoff mit aufladungsgefährdeter Oberfläche und Verwendung hierfür.**

(30) Priorität: **19.07.78 DE 2831791**

(43) Veröffentlichungstag der Anmeldung:
**23.01.80 Patentblatt 80/2**

(45) Bekanntmachung des Hinweises auf die Patenterteilung:
**12.08.81 Patentblatt 81/32**

(84) Benannte Vertragsstaaten:
**BE CH FR GB IT LU NL SE**

(56) Entgegenhaltungen:
**CH-A-414 302**
**DE-A-1 948 183**
**DE-A-2 303 358**

(73) Patentinhaber: **GKSS-Forschungszentrum Geesthacht GmbH, Reaktorstrasse 7-9,**
**D-2054 Geesthacht-Tesperhude (DE)**

(72) Erfinder: **Malxner, Uwe, Bündweg 28, D-3143 Barum (DE)**
Erfinder: **Milferstädt, Dieter, Wolfshorn 3,**
**D-3141 Tespe-Bütlingen (DE)**

(74) Vertreter: **von Bezold, Dieter, Dr. et al, Patentanwälte Dr. D. von Bezold, Dipl.-Ing. P. Schütz, Dipl.-Ing. W. Heusler Maria-Theresia-Strasse 22,**
**Postfach 86 02 60 D-8000 München 86 (DE)**

BUNDESDRUCKEREI BERLIN

## Bauteil aus metallischem Werkstoff mit aufladungsgefährdeter Oberfläche und Verwendung hierfür

Die Erfindung betrtifft ein Bauteil aus einem metallischen Werkstoff mit aufladungsgefährdeter Oberfläche. Insbesondere, jedoch nicht ausschließlich betrifft die Erfindung ein Bauteil aus metallischem Werkstoff für eine Hochvakuumanlage, das eine Oberfläche aufweist, deren elektrisches Potential einen in der Vakuumanlage verlaufenden Ladungsträgerstrahl zu beeinflussen vermag.

Es ist bekannt, daß eine elektrostatische Aufladung von isolierenden Flächen in einer Hochvakuumeinrichtung, die mit einem Ladungsträgerstrahl arbeitet, die Funktion einer solchen Einrichtung erheblich beeinträchtigen kann, da die durch die elektrostatische Aufladung erzeugten elektrostatischen Störfelder häufig eine unerwünschte Ablenkung der geladenen Teilchen verursachen.

Eine lokale Ansammlung störender elektrostatischer Oberflächenladungen auf einer dem Vakuum ausgesetzten Oberfläche eines Bauteils einer Hochvakuumeinrichtung kann jedoch nicht nur dann auftreten, wenn das Bauteil aus einem elektrisch isolierenden Material, wie Glas oder Keramik besteht, sondern auch, wenn es sich um ein Bauteil aus einem Metall handelt, auf dem sich während der Herstellung oder im Betrieb eine isolierende Oberflächenschicht gebildet hat. Insbesondere die Oxide vieler Metalle, die für Bauteile in Hochvakuumeinrichtungen verwendet werden, wie Aluminium, Kupfer, Tantal, Chrom und der Eisenmetalle, bilden Oxidschichten, die schon bei sehr geringen Schichtdicken gut isolieren und zu störenden Ladungsansammlungen auf der Oberfläche des Bauteils führen können, insbesondere, wenn verhältnismäßig viele Ladungsträger pro Zeiteinheit auf die betreffende Oberfläche auftreffen.

Auch bei vielen anderen Geräten und Anlagen können Probleme dadurch auftreten, daß eine Metalloberfläche, die im Betrieb des betreffenden Gerätes der Atmosphäre oder einem Gas von Atmosphärendruck und darüber ausgesetzt ist, durch Oxidation oder anderweitige Veränderung elektrisch isolierend oder zumindest schlecht leitend geworden ist, insbesondere wenn die Oberfläche im Betrieb mit einem elektrischen Feld in Wechselwirkung treten soll und/oder wenn eine lokale Aufladung der Oberfläche Störungen verursachen kann. Beispiele hierfür sind Elektroden von Drehkondensatoren, Strahler und Antennen für elektromagnetische Wellen, insbesondere für Ultrakurz- und Mikrowellen, wie Hornstrahler und Parabolspiegelantennen, Hohlleiter, Hohlraumresonatoren, aber auch Kontaktflächen und Oberflächen des Stators bzw. Rotors einer Zentrifuge (insbesondere Ultrazentrifuge) oder Turbomolekularpumpe, also Flächen, die sich im Betrieb mit hoher Geschwindigkeit (z. B. mehr als 10 m/s) in bezug aufeinander bewegen.

Hier will die Erfindung Abhilfe schaffen. Die Erfindung, wie sie in den Ansprüchen gekennzeichnet ist, löst die Aufgabe, die Oberfläche eines Bauteils aus Metall derart auszugestalten, daß keine unerwünschten Oberflächenladungen auftreten können bzw. daß trotz der normalerweise auf die Oberfläche einwirkenden Einflüsse eine ausreichende Oberflächenleitfähigkeit erhalten bleibt. Insbesondere soll die Oberfläche eine Schicht aus einer leitenden oder halbleitenden chemischen Verbindung tragen, die gegen die bei der bestimmungsgemäßen Verwendung auf die Oberfläche einwirkenden Einflüsse, insbesondere gegen Sauerstoff, beständig ist. Vorzugsweise ist die Verbindung ein elektrisch relativ gut leitendes Nitrid, wie Zirkonium- oder Titannitrid, oder Zirkonium- oder Titansilicid.

Bei der Verbindung handelt es sich vorzugsweise um eine Verbindung mindestens eines Metalls, das in dem metallischen Werkstoff des Bauelements enthalten ist.

Vorzugsweise besteht der metallische Werkstoff ganz oder teilweise aus Titan und/oder Zirkonium und die die Oberfläche bildende Verbindung ist Titannitrid und/oder Zirkoniumnitrid und/oder Titansilicid und/oder Zirkoniumsilicid.

Die durch die Erfindung erzielten Vorteile sind im wesentlichen darin zu sehen, daß die erfindungsgemäße Oberflächenschicht das Auftreten störender lokaler Aufladungen und elektrisch undefinierter Verhältnisse an der Grenze zwischen dem betreffenden Bauteil und seiner Umgebung verhindert, außerdem wirkt sie als Schutzschicht, z. B. gegen Oxidation. Die erfindungsgemäße Oberflächenschicht verringert ferner auch die elektrische Trägheit des Ansprechens von Elektrodenanordnungen, da der Aufbau und Abbau von Polarisations- und Influenzladungen auf und vor den Elektrodenoberflächen unterbleibt.

Es ist zwar aus der DE-OS 26 39 033 bekannt, Bauteile für Hochvakuumanlagen aus Metallen mit niedriger Zerstäubungsrate und sehr kleiner Desorptionsrate, wie Titan, Zirkonium und ähnlichen Werkstoffen und deren Legierungen herzustellen; auf die elektrische Beschaffenheit der Oberfläche wird dort jedoch nicht eingegangen. Dasselbe gilt für die DE-OS 25 00 339, aus der eine Teilchenfalle für molekulare, atomare oder subatomare Teilchen bekannt ist, die aus einem dreidimensionalen Netzwerk besteht, das eine Vielzahl von miteinander verbundenen freien Zellen bildet und aus Graphit, Kupfer Nickel, Chrom, Eisen, Titan, Wolfram, Kobalt, Molybdän und dgl. bestehen kann. Bei dieser Teilchenfalle wird aber auf eine aufladungsfreie Oberfläche kein Wert gelegt, so daß durch mögliche unerwünschte Oberflächenladungen eine Aufsammlung von Ladungsträgern erschwert oder sogar verhindert wird. Im Gegensatz dazu können Bauelemente mit erfindungsgemäß ausgestalteter Oberfläche, insbesondere Bauelemente mit einer Vielzahl enger Löcher, wie sie aus der DE-OS 26 39 033 ohne spezielle Oberflächenausgestaltung bekannt sind, auch als langzeitig stabile und unempfindliche Teilchenfalle für geladene Teilchen verwendet werden.

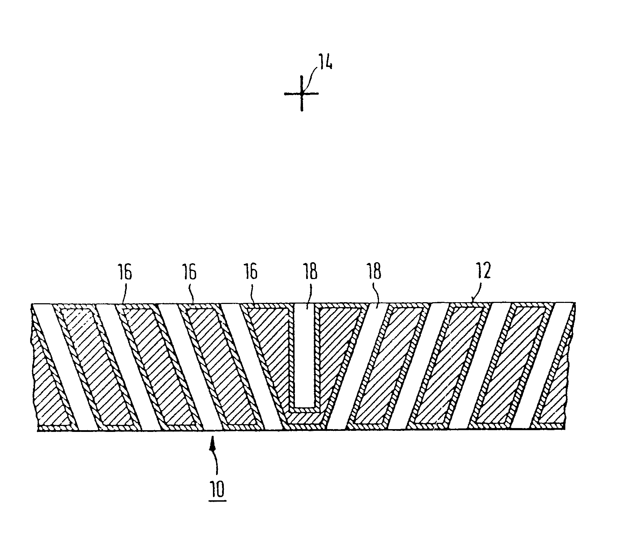

Im folgenden werden Ausführungsbeispiele der Erfindung unter Bezugnahme auf die Zeichnung näher erläutert, deren einzige Figur als spezielles, jedoch nicht ausschließliches Anwendungsbeispiel der Erfindung einen Teil eines plattenförmigen metallischen Bauteils für eine Hochvakuumeinrichtung darstellt.

Bei dem in der Zeichnung nur teilweise und stark vergrößert dargestellten Bauteil 10 kann es sich um eine Blende, eine Zwischenwand oder irgendein anderes Bauteil für eine Hochvakuumeinrichtung handeln, das eine Oberfläche 12 aufweist, deren elektrisches Potential einen in der Vakuumanlage verlaufenden, nur schematisch angedeuteten, senkrecht zur Zeichenebene und parallel zur Oberfläche 12 verlaufenden Ladungsträgerstrahl 14 zu beeinflussen vermag. Im allgemeinen wird es sich hier um Oberflächen handeln, die vom Weg des Ladungsträgerstrahles aus sichtbar sind; es gibt jedoch auch Fälle, bei denen der Strahl durch Felder beeinflußt werden kann, die von Ladungen auf Oberflächen ausgehen, welche vom Strahlweg aus nicht sichtbar sind.

Bei den konventionellen Bauteilen, z. B. aus Aluminium oder Eisenmetallen bilden sich im Laufe der Herstellung, des Aufheizens oder sogar im Betrieb Oberflächenschichten, z. B. Oxidschichten, die elektrisch sehr gut isolieren und daher das Auftreten von lokalen Oberflächenladungen ermöglichen. Gemäß der vorliegenden Erfindung wird dies dadurch verhindert, daß die Oberfläche eine Schicht 16 aus einer leitenden oder halbleitenden chemischen Verbindung trägt. Die Verbindung muß so gewählt werden, daß sie ihre leitenden oder halbleitenden Eigenschaften bei der üblichen Verwendung des Bauelements 10 beibehält, also auch beim Belüften der Vakuumanlage, beim Auftreffen von Ladungsträgern, die aus dem Strahlweg herausgestreut werden und dgl.

Vorzugsweise ist das Bauteil 10 zusätzlich noch so ausgebildet, wie es die bereits erwähnte DE-OS 26 39 033 lehrt. Es kann also (muß jedoch nicht) eine Vielzahl von eng beieinanderliegenden, im wesentlichen zylindrischen Öffnungen 18 aufweisen, die, wie dargestellt, als Durchgangsöffnungen (oder alternativ als Sacklöcher) ausgebildet sein können. Die Öffnungen oder Löcher verlaufen im wesentlichen senkrecht zur Oberfläche 12, wobei der Begriff »im wesentlichen senkrecht« nicht zu eng auszulegen ist und auch eine gewisse Schrägstellung mit umfassen soll, die, wie in der Zeichnung dargestellt, bewirkt, daß vom Weg des Strahles 14 aus gesehen kein gerader Durchblick durch die Öffnungen möglich ist oder Teilchen, die vom Strahlweg aus in Strahlrichtung nach vorne gestreut werden, nicht auf geradem Wege durch die Öffnungen treten können. Die Tiefe der Öffnungen soll im allgemeinen größer als ihr Durchmesser sein, der Durchmesser ist vorzugsweise kleiner als 0,5 mm und vorzugsweise nehmen die Öffnungen 65 bis 86% der Oberfläche ein.

Der Querschnitt der Löcher kann mit zunehmendem Abstand von der Oberfläche des Bauteils kleiner werden; die Oberflächenschicht 16 kann sich auch in die Löcher hinein erstrecken und deren Wände ganz oder teilweise bedecken.

Die Schicht 16 kann zum Beispiel aus Titannitrid oder Titansilicid bestehen. Wenn das Bauteil 10 aus Titan besteht, kann die Titan-Nitridschicht oder -Silicidschicht in situ gebildet werden.

Titannitrid hat den besonderen Vorteil, daß es sehr stabil ist und einen um etwa den Faktor 2 kleineren spezifischen elektrischen Widerstand hat als metallisches Titan. Titanoxide, deren Bildung durch die Titannitridschicht verhindert wird, haben dagegen einen sehr viel höheren spezifischen Widerstand als metallisches Titan.

Eine Schicht 16 aus Titannitrid auf einem Bauteil 10 aus Titan läßt sich z. B. chemisch herstellen, wobei man z. B. analog der bekannten Nitrierhärtung von Stählen vorgehen kann. TiN kann auch durch Reaktion von $TiCl_4$ mit $N_2$ in einem Wasserstoffplasma, oder durch Aufwachsverfahren u. a. m. hergestellt werden. Entsprechendes gilt auch für Zirkonium anstelle von Titan.

Eine Nitridschicht läßt sich häufig auch in der fertigen Vakuumeinrichtung dadurch herstellen, daß man die Vakuumeinrichtung mit einer Stickstoff-Füllung unter geeignet niedrigem Druck so betreibt, daß eine Oberflächenschicht der gewünschten Bauteile durch die Wechselwirkung zwischen dem Strahl, bzw. aus dem Strahl gestreuten Ladungsträgern, und dem Stickstoff an der Oberfläche entsteht. Dieses Vorgehen kann mehrmals wiederholt werden (»periodische Formierung der Oberfläche der Bauteile der Einrichtung«) und hat den Vorteil, daß die Nitridschicht im allgemeinen überall dort automatisch entsteht, wo sie benötigt wird. Voraussetzung ist natürlich, daß das Bauteil einen Nitridbildner, wie Titan oder Zirkonium, enthält, der ein Nitrid genügend niedriger Leitfähigkeit bildet.

Die Oberflächenschicht soll im allgemeinen einen Flächenwiderstand von weniger als $10^7$ Ohm aufweisen. Vorzugsweise ist der Flächenwiderstand jedoch wesentlich niedriger, z. B. $10^2$ Ohm und darunter.

Die Dicke der Schicht ist nicht kritisch, sie kann z. B. zwischen etwa 10 Nanometer und 1 Mikrometer liegen. Wenn das Bauteil 10 aus einem getternden Metall, wie Titan, besteht und selbst noch als Volumengetter arbeiten soll, so sollte die Schichtdicke nur so stark sein, wie es nötig ist, um die erwünschte Oberflächenleitfähigkeit aufrecht zu erhalten. Dagegen ist eine stärkere TiN-Schicht auf dem Titan nötig, wenn die Volumengetterung vermieden werden soll, z. B. bei gasgefüllten Systemen, wie H$_2$-Thyratrons, elektrisch gepumpten Gaslasern und dgl.

Bei der Herstellung der vorliegenden Oberflächenschichten ist es selbstverständlich wichtig, daß nicht zusätzlich noch isolierende Schichten entstehen, wie sie z. B. bei einer galvanischen Veredelung einer Oberfläche (z. B. beim Vergolden von Kupfer) zwischen Substrat und abgeschiedener Schicht entstehen können. Die Schicht muß also auf eine saubere Metalloberfläche aufgebracht oder auf dieser gebildet werden und bei der Bildung in situ durch Wechselwirkung zwischen Strahl, Stickstoff und z. B. Titan muß die Anwesenheit von Sauerstoff vermieden werden, damit keine hochisolierende Oxidschicht entsteht.

Die Oberflächenschicht 16 verhindert nicht nur das Entstehen von unerwünschten Oberflächenladungen, sondern verringert häufig eine beim Betrieb der Vakuumeinrichtung auftretende Oberflächenzerstäubung und stellt wegen ihrer hohen Schmelztemperatur (bei Titan- und Zirkoniumnitrid über 2500° C) einen wirksamen Aufschmelzschutz dar.

Das interessierende Konstruktionselement braucht nicht aus massivem Titan und/oder Zirkonium bestehen, es kann vielmehr aus beliebigem Material bestehen und nur einen z. B. aus Titan und/oder Zirkonium bestehenden, z. B. schichtförmigen Oberflächenbereich aufweisen, der mit der erfindungsgemäßen Oberflächenschicht versehen ist und das »Bauteil« im Sinne der vorliegenden Erfindung darstellt.

Die Oberflächenschicht aus TiN und anderen geeigneten Verbindungen ist schließlich auch völlig unmagnetisch, was für viele Anwendungen von Vorteil ist.

**Patentansprüche**

1. Bauteil aus metallischem Werkstoff mit einer aufladungsgefährdeten Oberfläche, dadurch gekennzeichnet, daß die Oberfläche (12) mit einer Schicht (16) aus einer leitenden oder halbleitenden Verbindung versehen ist, die in direktem elektrischen Kontakt mit dem metallischen Werkstoff des Bauteils steht und gegen die Einflüsse, die bei bestimmungsgemäßem Gebrauch des Bauteils auf sie einwirken, im wesentlichen beständig ist.

2. Bauteil nach Anspruch 1, dadurch gekennzeichnet, daß es sich bei der Verbindung um eine Verbindung mindestens eines Metalles handelt, das in dem metallischen Werkstoff enthalten ist.

3. Bauteil nach Anspruch 1 oder 2, dadurch gekennzeichnet, daß der metallische Werkstoff mindestens zum Teil aus Titan und/oder Zirkonium besteht.

4. Bauteil nach Anspruch 3, dadurch gekennzeichnet, daß die Schicht aus Titannitrid besteht.

5. Bauteil nach Anspruch 3, dadurch gekennzeichnet, daß die Schicht aus Titansilicid besteht.

6. Bauteil nach Anspruch 3, dadurch gekennzeichnet, daß die Schicht aus Zirkoniumnitrid besteht.

7. Bauteil nach einem der vorhergehenden Ansprüche, dadurch gekennzeichnet, daß es eine Vielzahl von Löchern aufweist.

8. Bauteil nach Anspruch 7, dadurch gekennzeichnet, daß die Löcher mindestens 65% der Oberfläche einnehmen.

9. Bauteil nach Anspruch 7 oder 8, dadurch gekennzeichnet, daß der Durchmesser der Löcher an der Oberfläche kleiner als 0,5 mm ist.

10. Bauteil nach Anspruch 7, 8 oder 9, dadurch gekennzeichnet, daß die Schicht die Wände der Löcher (18) mindestens teilweise bedeckt.

11. Verwendung des Bauteils nach einem der vorangehenden Ansprüche in einer Vakuumeinrichtung, insbesondere einer Ladungsträgerstrahleinrichtung, wobei die Schicht im Betrieb der Einrichtung dem Vakuum ausgesetzt ist.

12. Verwendung nach Anspruch 11, dadurch gekennzeichnet, daß die Schicht eine vom Weg eines Ladungsträgerstrahles (14) aus sichtbare Oberfläche bedeckt.

13. Verwendung des Bauteils nach einem der Ansprüche 1 bis 10 in einem elektrischen Gerät, bei dem die Oberfläche im Betrieb des Geräts mit einem elektrischen Feld in Wechselwirkung tritt.

14. Verwendung des Bauteils nach einem der Ansprüche 1 bis 10 in einem Gerät, das zwei einander gegenüberliegende Oberflächen aufweist, die sich im Betrieb des Gerätes mit hoher Geschwindigkeit in bezug aufeinander bewegen, insbesondere in einer Zentrifuge oder Molekularpumpe.

15. Verwendung des Bauteils nach einem der Ansprüche 1 bis 10 in einem Gerät, bei dem das Bauteil Ladungsträgern ausgesetzt ist und als Teilchenfalle für Ladungsträger arbeitet.

16. Verwendung des Bauteils nach einem der Ansprüche 1 bis 10 als Schaltkonktakt.

**Claims**

1. A structural member made from a metallic material, comprising a surface prone to charge accumulation thereon, characterized in that said surface (12) is provided with a layer (16) made from a conductive or semiconductive compound, said layer being in direct electrical contact with said metallic material of the structural member, said layer exhibiting stable properties during influences to which the structural member is exposed during intended use.

2. The structural member according to claim 1, characterized in that said said compound is the compund of at least one metal comprised in said metallic material.

3. The structural member according to claim 1 characterized in that said metallic material consists at least in part of titanium and/or zirconium.

4. The structural member according to claim 3 characterized in that said layer sonsists of titanium nitride.

5. The structural member according to claim 3 characterized in that said layer consists of titanium silicide.

6. The structural member according to claim 3, characterized in that said layer consists of zirconium nitride.

7. The structural element according to any of the preceding claims, characterized in that said structural member has a plurality of holes formed therein.

8. The structural member according to claim 7, characterized in that the holes occupy at least 65% of said surface.

9. The structural member according to claim 7 or 8, characterized in that the diameter of the holes at said surface is less than 0,5 mm.

10. The structural member according to claim 7, 8 or 9 characterized in that said layer covers at least part of the walls of said holes (18).

11. The use of the structural member according to any of the preceding claims, in a vacuum arrangement, especially a charge carrier beam arrangement, wherein the layer ist exposed during operation to vacuum.

12. The use as claimed in claim 11, wherein the layer covers a surface which is in the line of sight with respect to the path of the charge carrier beam (14).

13. The use of the structural member according any of claims 1 to 10, in an electrical apparatus, in which said surface during operation of the apparatus interacts with an electric field.

14. The use of the structural member according any of claims 1 to 10 in an apparatus which comprises a pair of opposed surfaces, which during operation of said apparatus move at a high speed with respect to each other, such as in a centrifuge or in a molecular pump.

15. The use of the structural member according to any of claim 1 to 10 wherein said member is exposed to charge carriers and operates as particle trap for said charge carriers.

16. The use of the structural member according to any of claims 1 to 10 as switching contact.

## Revendications

1. Elément en matériau métallique comprenant une surface exposée à des charges électriques, caractérisé en ce que la surface (12) est pourvue d'une couche (16) d'un composé conducteur ou semiconducteuer, qui est en contact électrique direct avec le matériau métallique de l'élément et est essentiellement résistant aux facteurs ayant une influence sur cette surface lorsque l'élément est soumis à l'utilisation à laquelle il est destiné.

2. Elément selon la revendication 1, caractérisé en ce que le composé est un composé d'au moins un métal contenu dans le matériau métallique.

3. Elément selon la revendication 1 ou 2, caractérisé en ce que le matériau métallique est constitué au moins par une partie en titane et/ou en zirconium.

4. Elément selon la revendication 3, caractérisé en ce que la couche est constituée par du nitrure de titane.

5. Elément selon la revendication 3, caractérisé en ce que la couche est constituée par du siliciure de titane.

6. Elément selon la revendication 3, caractérisé en ce que la couche est constituée par du nitrure de zirconium.

7. Elément selon l'une quelconque des revendications précédentes, caractérisé en ce qu'il comprend une pluralité de trous.

8. Elément selon la revendication 7, caractérisé en ce que les trous occupent au moins 65% de la surface.

9. Elément selon la revendication 7 ou 8, caractérisé en ce que le diamètre des trous, sur la surface, est inférieur à 0,5 mm.

10. Elément selon la revendication 7, 8 ou 9, caractérisé en ce que la couche recouvre au moins partiellement les parois des trous (18).

11. Utilisation de l'élément selon l'une quelconque des revendications précédentes, dans un dispositif à vide et en particulier un dispositif à rayon porteur de charges, dans lequel la couche est soumise au vide lors de l'utilisation du dispositif.

12. Utilisation selon la revendication 11, caractérisée en ce que la couche recouvre une surface visible du parcours d'un rayon porteur de charges (14).

13. Utilisation de l'élément selon l'une quelconque des revendications 1 à 10 dans un appareil électrique, dans lequel la surface interagit avec un champ électrique lors du fonctionnement de l'appareil.

14. Utilisation de l'élément selon l'une quelconque des revendications 1 à 10 dans un appareil comprenant deux surfaces se faisant face et se déplaçant à grande vitesse l'une par rapport à l'autre quand l'appareil fonctionne, en particulier dans une centrifugeuse ou une pompe moléculaire.

15. Utilisation de l'élément selon l'une quelconque des revendications 1 à 10 dans un appareil dans lequel l'élément est soumis à des porteurs de charges et fonctionne en tant que piège à particules pour les porteurs de charge.

16. Utilisation de l'élément selon l'une quelconque des revendications 1 à 10 en tant que contact de commutateur.